# DEMANDE DE BREVET EUROPEEN

(11) **EP 2 818 586 A1**
(43) Date de publication de la demande: **31.12.2014**
(21) Numéro de dépôt: 14174762.6
(22) Date de dépôt: 27.06.2014
(51) Int. Cl.: C30B 1/02, C30B 29/06, H01L 21/02

(54) **Electrode avec couche de nucléation pour épitaxie**

(30) Priorité: 28.06.2013 FR 1356316
(71) Demandeur: SAINT-GOBAIN RECHERCHE, 93300 Aubervilliers (FR); CENTRE NATIONAL DE LA RECHERCHE SCIENTIFIQUE, 75794 Paris Cedex 16 (FR)
(72) Inventeur: Harmand, Jean-Christophe, 91240 Saint Michel Sur Orge (FR); Sondergard, Elin, 94230 Cachan (FR); Cohin, Yann, 75013 Paris (FR)
(74) Mandataire: Pöpping, Barbara

(57) **Abrégé**

L'invention concerne une électrode comportant une couche de nucléation pour la croissance épitaxiale, comportant successivement
(a) une couche électro-conductrice présentant une rugosité de surface telle que le Rq (norme ISO 4287) est inférieur à 20 nm, de préférence inférieure à 10 nm, en particulier inférieure à 5 nm, ladite couche électro-conductrice étant de préférence supportée par un substrat,
(b) une couche barrière d'un nitrure métallique électro-conducteur choisi parmi les nitrures de titane (TiN), de bore (BN), de tantale (TaN), d'aluminium (AlN), de tungstène (W₂N), de molybdène (Mo₂N), de niobium (NbN) et de chrome (CrN), présentant une épaisseur comprise entre 2 nm et 100 nm, de préférence entre 5 et 50 nm et en particulier entre 8 et 20 nm, et
(d) une couche de silicium et/ou de germanium cristallin constituée d'un ou plusieurs monocristaux, jointifs ou non, tous orientés de sorte que leur plan cristallin (111) soit sensiblement parallèle à la surface de la couche barrière et présentant une épaisseur inférieure à 100 nm, de préférence comprise entre 10 et 80 nm, en particulier entre 15 et 50 nm.

## Description

La présente invention concerne une électrode portant une couche de nucléation pour la croissance épitaxiale de semiconducteurs, un précurseur d'une telle électrode qui comprend un précurseur amorphe de la couche de nucléation, ainsi qu'un procédé pour fabriquer ledit précurseur d'électrode et un procédé pour convertir le précurseur en électrode.

De très nombreux dispositifs électroniques ou optoélectroniques tels que des cellules photovoltaïques, des transistors à film mince, des diodes électro-luminescentes, des diodes lasers, des photocathodes, etc., comportent, en tant que matériau actif, un matériau semi-conducteur cristallin généralement obtenu par épitaxie sur un substrat cristallin.

Les propriétés et performances du dispositif dépendent notamment de l'orientation et de la taille du ou des cristaux constituant le matériau actif, qui dépendent, à leur tour, de l'état de surface et de la cristallinité du substrat sous-jacent qui sert de « germe de nucléation » (en anglais *seed)* à la croissance épitaxiale.

L'épitaxie de matériaux actifs semi-conducteurs pour dispositifs électroniques ou optoélectroniques se fait donc classiquement sur des substrats monocristallins massifs, typiquement Si(100) ou GaAs(100), dont la fabrication est toutefois coûteuse.

Il a par conséquent été proposé de remplacer les substrats monocristallins massifs, utilisés classiquement, par des couches minces monocristallines ou polycristallines constituées de cristaux ayant une étendue et une orientation appropriées. Une technique intéressante pour fabriquer des couches minces de silicium polycristallin sur des substrats non conducteurs est la cristallisation induite par l'aluminium (AIC, de l'anglais *Aluminum Induced crystallization*) décrite par exemple dans WO 2011/026915. Cette technique comprend le dépôt de deux couches minces, à savoir une couche de silicium amorphe (a-Si) au contact d'une couche d'aluminium, sur un substrat, et le recuit de l'ensemble à une température comprise entre la température de cristallisation induite du silicium (160 °C environ) et la température de fusion de l'eutectique Si/Al (à 577 °C).

Au cours de ce recuit il se produit la diffusion des atomes de silicium entre les grains d'aluminium, la nucléation de germes cristallins de silicium et la cristallisation du silicium qui aboutit, à la fin du processus, à l'inversion des positions respectives des deux couches.

Ainsi lorsqu'on dépose d'abord une couche d'aluminium puis, au-dessus de celle-ci, une couche de silicium amorphe, on obtient après recuit une couche de silicium cristallin recouverte d'une couche d'aluminium et éventuellement de résidus de silicium n'ayant pas diffusé à travers la couche d'aluminium. Après élimination de l'aluminium et des résidus de silicium, par exemple par gravure chimique, on obtient une mince couche de silicium cristallin qui peut jouer le rôle de couche de nucléation pour l'épitaxie.

Lorsque l'aluminium est déposé sur le silicium amorphe, l'inversion des positions aboutit à la formation d'une couche de silicium cristallin sur une couche d'aluminium qui n'a alors pas besoin d'être éliminée.

Par ailleurs, il serait souhaitable de pouvoir fabriquer de telles couches minces mono- ou polycristallines de « nucléation » ou « germination » (en anglais *seed layer)* sur des couches ou substrats électro-conducteurs, transparents ou non, susceptibles de jouer le rôle d'électrode dans les dispositifs finals.

L'article de Widenborg *et al.* (Per Widenborg et al., « Back electrode formation for poly-Si thin film solar cells on glass having AlC-grown seeding layer », Solar Energy Materials & Solar Cells 74 (2002) 305 - 314) décrit ainsi la fabrication de couches de silicium polycristallin par cristallisation induite par l'aluminium sur des couches électro-conductrices (Al, Mo et TiN) supportées par du verre. Ces auteurs mettent en évidence des problèmes d'interaction entre le métal sous-jacent (Mo, Al) et la bicouche Al/a-Si. Pour isoler le collecteur de courant de la bicouche Al/a-Si, il a été envisagé de les séparer par une couche barrière qui s'oppose à diffusion des atomes. Cette couche doit bien entendu avoir une certaine conductivité électronique pour permettre le passage des électrons dans le dispositif final entre l'électrode (collecteur de courant) et le matériau actif semi-conducteur épitaxié.

A la connaissance de la Demanderesse un seul article a fait jusqu'ici état de l'utilisation d'une telle couche barrière. Il a ainsi été proposé par Delachat *et al.* de produire une couche de silicium polycristallin (p-Si) par AlC sur des substrats métalliques (F. Delachat et al. « Thin film pc-Si by aluminium-induced crystallization on metallic substrate », EPJ Photovoltaics 4, 45102 (2013)).

Les auteurs appliquent sur des feuilles métalliques en acier ferritique d'abord une couche barrière en TaN puis une couche d'aluminium qu'ils laissent s'oxyder pendant une semaine avant d'y déposer par pulvérisation cathodique magnétron une couche de silicium amorphe (a-Si).

L'épaisseur de la couche de TaN est d'environ 1 µm, celle de la couche d'aluminium d'environ 200 nm et celle de la couche de silicium amorphe d'environ 400 nm.

Le recuit de cet empilement à une température supérieure à la température de cristallisation induite du silicium amorphe au contact de l'aluminium (env. 160 °C) et inférieure à la température de l'eutectique Si/Al (égale à 577 °C), aboutit à la formation d'une couche de silicium polycristallin (dopage de type p) directement en contact avec la couche TaN. La couche de silicium est surmontée d'une couche résiduelle de Si et Al qui est éliminée par gravure. L'analyse de la couche de silicium polycristallin mise à nue par gravure montre que les cristaux de Si formés ont une taille moyenne d'environ 15 µm et une orientation préférentielle <100> avec une large dispersion des angles, de l'ordre de 15 °.

En mettant en oeuvre un procédé similaire à celui décrit dans l'article de Delachat mais en utilisant des substrats métalliques considérablement moins rugueux permettant le dépôt de couches beaucoup plus fines que celles décrites par Delachat *et al.* la Demanderesse a constaté avec une grande surprise que, non seulement les cristaux de silicium qu'elle obtenait avaient un rapport d'aspect (dimension latérale/épaisseur) significativement plus grand que ceux obtenus par Delachat *et al.,* mais que l'orientation des cristaux de silicium formés était différente de celle mise en évidence par Delachat.

Ainsi, en déposant sur un collecteur de courant très peu rugueux, une couche barrière très fine, puis sur cette fine couche barrière une couche d'aluminium et une couche de silicium amorphe de moins de 100 nm chacune et en soumettant l'empilement à un recuit, la Demanderesse a obtenu une couche de silicium très mince constituée d'une pluralité de monocristaux de silicium ayant tous une orientation [111], autrement dit une orientation telle que leurs plans cristallins (111) sont sensiblement parallèles à la surface de la couche barrière avec laquelle les monocristaux de silicium sont en contact. Les couches polycristallines obtenues grâce au procédé de la présent invention se distinguent par ailleurs par le fait que pratiquement tous les cristaux ont un plan (111) sensiblement parallèle à l'interface avec la couche barrière sous-jacente, plus précisément au moins 90 % des cristaux Si(111) ont un plan (111) qui forme un angle de moins de 10 ° avec cette l'interface.

Une telle orientation [111], assez inhabituelle, pourrait être intéressante
- pour la croissance de nanofils selon un axe perpendiculaire à la surface de la couche de nucléation,
- pour la croissance de semi-conducteurs des groupes II-VI, III-V ou IV ou pour la communication inter-puces,
- pour l'élaboration de plaquettes épitaxiées de GaN pour l'émission et la réception de lumière.

La présente invention a ainsi pour objet une électrode comportant une couche de nucléation pour la croissance épitaxiale de semiconducteurs, ladite électrode comportant successivement
(a) une couche électro-conductrice présentant une rugosité de surface telle que le Rq (norme ISO 4287) est inférieur à 20 nm, de préférence inférieure à 10 nm, en particulier inférieure à 5 nm, ladite couche électro-conductrice étant de préférence supportée par un substrat,
(b) une couche barrière d'un nitrure métallique électro-conducteur choisi parmi les nitrures de titane (TiN), de bore (BN), de tantale (TaN), d'aluminium (AIN), de tungstène (W₂N), de molybdène (Mo₂N), de niobium (NbN) et de chrome (CrN), présentant une épaisseur comprise entre 2 nm et 100 nm, de préférence entre 5 et 50 nm et en particulier entre 8 et 20 nm, et
(d) une couche de silicium et/ou de germanium cristallin constituée d'un ou plusieurs monocristaux, jointifs ou non, tous orientés de sorte que leur plan cristallin (111) soit sensiblement parallèle à la surface de la couche barrière et présentant une épaisseur inférieure à 100 nm, de préférence comprise entre 10 et 80 nm, en particulier entre 15 et 50 nm.

La présente invention a également pour objet le précurseur d'une telle électrode, qui est dépourvu de couche de silicium et/ou de germanium cristallin, mais comporte une double couche constituée d'une couche de silicium amorphe et d'une couche d'un métal susceptible d'induire la cristallisation du silicium à une température appropriée.

Ce précurseur comporte successivement
(a) une couche électro-conductrice présentant une rugosité de surface telle que le Rq (norme ISO 4287) est inférieur à 20 nm, de préférence inférieure à 10 nm, en particulier inférieure à 5 nm, voire inférieure à 2 nm, ladite couche électro-conductrice étant de préférence supportée par un substrat,
(b) une couche barrière d'un nitrure métallique électro-conducteur choisi parmi les nitrures de titane (TiN), de bore (BN), de tantale (TaN), d'aluminium (AIN), de tungstène (W₂N), de molybdène (Mo₂N), de niobium (NbN) et de chrome (CrN), présentant une épaisseur comprise entre 2 nm et 100 nm, de préférence entre 5 et 50 nm et en particulier entre 8 et 20 nm,
(c) une couche d'un métal choisi parmi Al, Ag et Au, de préférence Al, et
(d) une couche de silicium et/ou germanium amorphe (a-Si), présentant une épaisseur inférieure à 100 nm, de préférence comprise entre 10 et 80 nm, en particulier entre 15 et 50 nm, directement en contact avec la couche,
l'ordre des couches (c) et (d) pouvant être inversé de manière à ce que la couche de silicium et/ou germanium amorphe (d) se trouve sous la couche d'Al, Ag ou Au (c).

Ce précurseur est un produit intermédiaire qui peut être commercialisé, c'est-à-dire stocké et transporté, et converti en électrode par simple recuit, éventuellement suivi d'une étape de nettoyage par gravure pour mettre à nu la couche de nucléation formée. Cette « activation » de la couche de nucléation peut ainsi se faire sur le site où est mise en oeuvre l'épitaxie, ce qui évite avantageusement des problèmes de contamination au cours du transport/stockage.

Le terme « couche de silicium et/ou de germanium » utilisé dans les revendications désigne une couche d'un matériau de formule Si₁₋ₓGeₓ où x vaut de 0 à 1, c'est-dire constitué de silicium ou de germanium ou de n'importe quel alliage de ces deux éléments. Par souci de simplification et sauf mention du contraire nous utiliseront ci-après dans la description de l'invention la plupart du temps le terme de « silicium » comme terme générique désignant un tel matériau à base de Si et/ou Ge.

Comme expliqué en introduction à propos de l'AlC, la couche de métal et la couche de silicium peuvent être déposées dans n'importe quel ordre.

Lorsque la couche de silicium amorphe (d) est déposée *sur* la couche de métal (c) le précurseur a une structure (a)-(b)-(c)-(d) et la cristallisation du silicium et l'inversion des couches aboutit à une structure (a)-(b)-(d)-(c). L'élimination par gravure de la couche (c) donne une électrode de structure (a)-(b)-(d).

Lorsque la couche de silicium amorphe (d) est déposée *sous* la couche de métal (c) le précurseur a une structure (a)-(b)-(d)-(c) et la cristallisation du silicium et l'inversion des couches aboutit à une structure (a)-(b)-(c)-(d), qui est la structure définitive de l'électrode car l'élimination de la couche (c) est impossible.

Dans le deuxième cas, l'électrode finale comporte donc, entre la couche barrière et la couche de silicium et/ou de germanium cristallin, une couche d'un métal choisi parmi Al, Ag, Au, de préférence une couche de Al.

Dans les deux cas, l'électrode comporte au moins les trois couches (a), (b) et (d), la couche (d) de silicium étant celle au contact de l'atmosphère.

La Demanderesse a observé que, pour garantir une qualité optimale de la couche de nucléation, il était conseillé de ne pas utiliser l'aluminium, ou l'or ou l'argent, en excès par rapport au silicium. La couche de métal a par conséquent de préférence une épaisseur comprise entre environ 70 % et 100 % de l'épaisseur de la couche de silicium. En cas de non-respect de ces proportions la couche de silicium cristallin formée est constituée de grains isolés ne couvrant pas entièrement la surface de l'électrode.

Une des caractéristiques techniques essentielles de la présente invention est la faible rugosité de la couche électro-conductrice. L'écart moyen quadratique Rq tel que défini dans la norme ISO 4287 (point 4.2.2) de la couche électro-conductrice peut être déterminé par analyse d'image d'un cliché de microscopie électronique d'une section transversale du précurseur ou de l'électrode finie, ou encore par rugosimétrie de la couche électro-conductrice avant dépôt de la couche barrière (λ_{c} = 0,8 µm).

Cette couche électro-conductrice peut-être une structure auto-supportée, telle qu'une feuille métallique, mais il s'agit de préférence d'une couche électro-conductrice déposée sur un substrat. Ce substrat peut être choisi parmi les substrats amorphes ou cristallins, minéraux ou organiques. A titre d'exemple de substrat amorphe convenant tout particulièrement à la présente invention, on peut citer les substrats en verre. A titre d'exemple de substrat cristallin massif convenant tout particulièrement à la présente invention, on peut citer les substrats de silicium massif présentant une orientation cristalline autre que (111), par exemple une orientation (001).

La couche conductrice peut être en n'importe quel matériau ayant une conductivité suffisante pour jouer le rôle d'électrode dans le dispositif électronique ou opto-électronique final. La résistance par carré (R□) de la couche conductrice est de préférence inférieure à 5 Ω/□, en particulier inférieure à 1 Ω/□ et de manière particulièrement préférée inférieure à 0,5 Ω/□.

La couche électro-conductrice est de préférence une couche métallique, en particulier une couche d'aluminium (Al), de molybdène (Mo), d'argent (Ag), de tungstène (W), d'or (Au), de cuivre (Cu), de titane (Ti), de chrome (Cr), de fer (Fe), de zinc (Zn) et leurs alliages, ou une couche d'un oxyde métallique conducteur choisi de préférence parmi les oxydes conducteurs transparents tels que l'oxyde de zinc dopé à l'aluminium, au gallium et/ou à l'indium, l'oxyde d'étain dopé à l'indium (ITO), l'oxyde d'étain et de zinc (SnZnO) ou le dioxyde d'étain (SnO₂).

Si nécessaire, cette couche peut être polie avant dépôt de la couche barrière.

La couche barrière (b), située entre la couche d'électrode (a) et la couche de silicium amorphe ou cristallin (d) ou la couche de métal (c), est chimiquement inerte vis-à-vis de ces couches et a pour rôle essentiel d'empêcher l'interaction entre ces matériaux au cours de l'étape de cristallisation du silicium (recuit). Elle doit en outre avoir une conductivité verticale suffisante pour permettre le passage des électrons entre le matériau actif et l'électrode dans le dispositif final. Certains nitrures métalliques tels que les nitrures de titane (TiN), de bore (BN), de tantale (TaN), d'aluminium (AIN), de tungstène (W₂N), de molybdène (Mo₂N), de niobium (NbN) et de chrome (CrN), présentent ces propriétés et sont donc parfaitement appropriées en tant que couche barrière.

L'épaisseur de la couche de nitrure nécessaire pour faire efficacement barrière entre les couches adjacentes dépend de la rugosité de la couche électro-conductrice. Plus celle-ci est faible, plus la couche barrière peut être mince. Ainsi pour un Rq inférieur à 2 nm une couche de nitrure de moins de 10 nm peut être suffisante, tandis que pour des Rq plus importants la couche de nitrure doit être plus épaisse. De préférence la valeur de l'épaisseur de la couche barrière est au moins quatre à cinq fois plus importante que le Rq.

La Demanderesse suppose en outre que certaines techniques de dépôt tels que le dépôt de couche atomique (ALD) qui donne des couches très denses, permette de réduire encore davantage l'épaisseur de la couche barrière.

Comme déjà expliqué ci-dessus, la couche de silicium cristallin est en contact soit directement avec la couche barrière, soit avec la couche métallique (Al, Ag, Au) ayant induit la cristallisation du silicium.

La couche de silicium cristallin peut être une couche continue constituée de plusieurs monocristaux ayant grandi jusqu'à confluence.

Dans un autre mode de réalisation particulièrement intéressant, la couche de silicium et/ou de germanium cristallin est constituée d'une pluralité de domaines non jointifs, chacun des domaines pouvant être constitué d'un monocristal unique ou de plusieurs monocristaux jointifs.

Une telle couche discontinue est obtenue par recuit d'une couche de silicium et/ou germanium amorphe constituée d'une multitude de domaines non jointifs, déposés par exemple à travers un masque ou créés par ablation laser d'une couche continue de silicium amorphe ou par abrasion ionique, réactive ou non réactive, à travers un masque de gravure. L'étendue de la couche métallique (Al, Au ou Ag) induisant la cristallisation du silicium/germanium est de préférence identique à celle de la couche de silicium/germanium. Ces deux couches peuvent être structurées par les mêmes techniques.

Chacun des domaines non jointifs a de préférence une étendue comprise entre 0,001 µm² et 10 cm².

Lorsque la taille des domaines de a-Si non contigus déposés est inférieure à la dimension moyenne d'un monocristal de silicium, un grand nombre de domaines seront constitués d'un monocristal unique. Lorsque la taille des domaines de a-Si déposés est significativement supérieure à la taille moyenne d'un monocristal, chaque domaine sera composé de plusieurs monocristaux jointifs ayant grandi jusqu'à la confluence.

La présente invention a également pour objet un procédé de fabrication d'une électrode telle que décrite ci-dessus, à partir d'un précurseur d'électrode, ledit procédé comprenant le chauffage dudit précurseur d'électrode - ayant une structure (a)-(b)-(c)-(d) ou (a)-(b)-(d)-(c) - à une température et pendant une durée suffisantes pour effectuer la cristallisation de la couche de silicium et/ou germanium amorphe au contact de la couche métallique et l'inversion des positions respectives des couches (c) et (d) dans l'empilement de couches, grâce à la diffusion des atomes de silicium/germanium de la couche (d) à travers la couche (c).

La température de recuit doit être supérieure à la température de cristallisation induite du silicium/germanium et inférieure à la température de fusion de l'eutectique du silicium/germanium avec le métal de la couche (c). Plus la température de recuit est élevée, plus la cristallisation est rapide et plus la durée de l'étape de recuit peut être courte.

La durée de recuit nécessaire pour obtenir une cristallisation complète du silicium amorphe dépend également du taux d'oxydation de la couche d'aluminium, autrement dit de la proportion d'Al₂O₃ à la surface de la couche d'aluminium (voir O. Nast et al., Journal of Applied Physics, 88(2) :716 - 724, 2000). On considère généralement que plus la couche d'oxyde est complète, plus elle agira comme une barrière de diffusion aux atomes de Si/Ge et ralentira l'inversion des couches Si/Ge et d'aluminium. Le temps nécessaire pour un recuit complet peut ainsi varier entre quelques secondes et plus de 40 heures.

L'ajustement de la température de recuit permet également de contrôler la taille moyenne des monocristaux : plus la température de recuit est proche de la température de cristallisation induite, plus le nombre de germes de nucléation par unité de surface est faible et plus la taille moyenne des monocristaux, en fin de cristallisation, sera importante.

De préférence la température de chauffage est comprise entre 250 °C et 550 °C, en particulier entre 300 °C et 500 °C, pour une durée de chauffage comprise entre 0,5 minute et 1 heure, de préférence entre 1 minute et 30 minutes.

Enfin, comme déjà mentionné en introduction, le procédé de conversion du précurseur en électrode porteuse d'une couche de nucléation en Si/Ge peut comporter en outre, après l'étape de cristallisation, une étape destinée à éliminer la couche métallique superficielle. Cette élimination peut se faire de manière connue par gravure chimique avec une solution d'acide phosphorique (80% d'acide phosphorique, 5% d'acide chlorhydrique, 5% d'acide acétique, et 10% d'eau), une solution de HF diluée à 5%, ou encore une solution d'acide chlorhydrique diluée à 10%. Elle est bien entendu superflue et même impossible lorsque la couche métallique se retrouve, après l'étape de cristallisation, en dessous de la couche de Si/Ge cristallisée.

La surface de la couche de silicium/germanium cristallisée est formée par un ou plusieurs monocristaux, jointifs ou non. Les plans cristallins (111) de tous ces monocristaux sont sensiblement parallèles les uns aux autres avec une dispersion des angles inférieure à 10°, sur certains échantillons inférieure à 5 °.

Le diamètre équivalent moyen des cristaux de Si/Ge (diamètre équivalent = diamètre du cercle ayant la même surface que la forme irrégulière) est de préférence compris entre 0,03 et 100 µm.

Le rapport d'aspect, défini comme le rapport du diamètre équivalent moyen à l'épaisseur de la couche de Si/Ge, des cristaux est supérieur à 100, voir supérieur à 500.

Enfin, l'invention a pour objet un procédé de fabrication d'un précurseur d'électrode qui donnera, après recuit, l'électrode de la présente invention.

Ce procédé comprend les étapes successives suivantes :
(i) dépôt d'une couche barrière d'un nitrure métallique électro-conducteur choisi parmi les nitrures de titane (TiN), de bore (BN), de tantale (TaN), d'aluminium (AIN), de tungstène (W₂N), de molybdène (Mo₂N), de niobium (NbN) et de chrome (CrN), présentant une épaisseur comprise entre 2 nm et 100 nm, de préférence entre 5 et 50 nm et en particulier entre 8 et 20 nm, sur une couche électro-conductrice présentant une rugosité de surface telle que le Rq (norme ISO 4287) est inférieur à 20 nm, de préférence inférieur à 10 nm, en particulier inférieur à 5 nm, la couche électro-conductrice pouvant être une structure autoportée ou être supportée par un substrat solide,
(ii) dépôt, sur la couche barrière déposée à l'étape (i), d'une bicouche formée d'une couche de silicium et/ou de germanium amorphe et d'une couche d'aluminium, les deux couches présentant chacune une épaisseur inférieure à 100 nm, de préférence comprise entre 10 et 80 nm, en particulier entre 15 et 50 nm, et pouvant être déposées dans n'importe quel ordre.

De manière connue, on prendra en outre soin de laisser la couche d'aluminium s'oxyder au moins en surface avant le dépôt de la couche de silicium et/ou germanium amorphe ou avant l'étape de recuit du précurseur. La présence d'une couche superficielle d'oxyde d'aluminium Al₂O₃ est en effet une condition nécessaire à l'obtention d'une couche de silicium cristallin de bonne orientation.

Le dépôt de la couche électro-conductrice sur le substrat, de la couche barrière sur la couche électro-conductrice, et de chacune des deux couches de la bicouche peut se faire selon des techniques familières à l'homme du métier, telles que le dépôt chimique en phase vapeur (CVD), avec ou sans plasma, en particulier le dépôt de couche atomique (ALD), le dépôt physique en phase vapeur (PVD), en particulier l'évaporation sous vide, la pulvérisation cathodique magnétron, la pulvérisation par faisceau d'ions ou l'ablation par laser pulsé. De préférence chacune des étapes (i) et (ii) se fait indépendamment par évaporation sous vide, par pulvérisation cathodique magnétron ou par dépôt de couche atomique (ALD).

L'invention est à présent illustrée à l'aide des figures ci-jointes dans lesquelles
la Fig. 1 montre schématiquement un premier mode de fabrication d'une électrode selon l'invention,
la Fig. 2 montre schématiquement un deuxième mode de fabrication d'une électrode selon l'invention,
la Fig. 3 montre schématiquement un troisième mode de fabrication d'une électrode selon l'invention.
la Fig. 4 montre deux clichés de microscopie électronique à balayage, et
la Fig. 5 montre les spectres de diffraction des rayons X de trois électrodes selon l'invention.

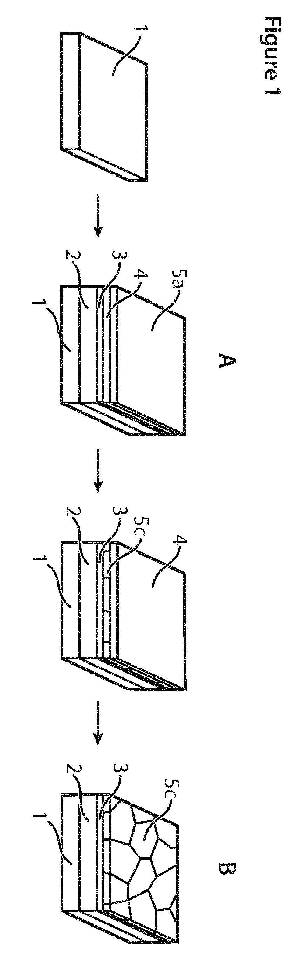

Dans le premier mode de réalisation représenté à la figure 1, on dépose sur un substrat 1 successivement une couche métallique 2, une couche barrière 3 en TiN, une couche d'aluminium 4, et une couche de silicium amorphe 5a. Après recuit, la couche de silicium amorphe s'est transformée en couche de silicium cristallin 5c et la position des couches d'aluminium 4 et de silicium 5c est inversée, la couche d'aluminium 4 étant la couche la plus à l'extérieur. L'élimination de cette couche d'aluminium 4 par gravure expose la couche de silicium cristallin 5c, constituée d'un certain nombre de monocristaux ayant grandi jusqu'à confluence.

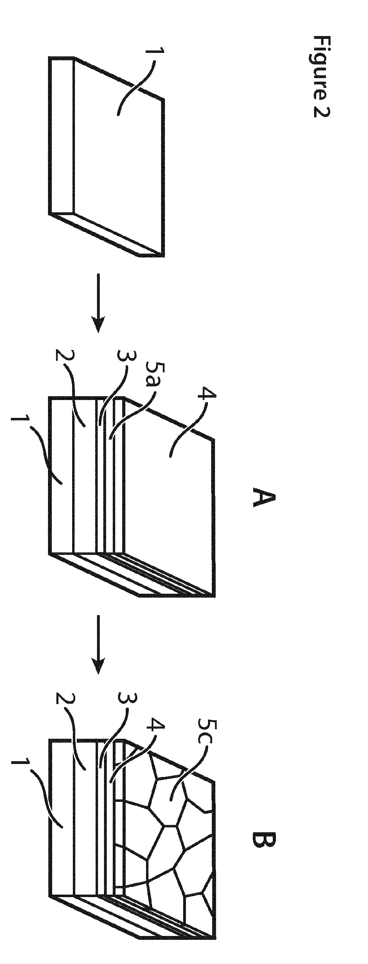

Le deuxième mode de réalisation représenté à la figure 2 diffère de celui de la figure 1 uniquement par l'ordre de dépôt des couches d'aluminium 4 et de silicium amorphe 5a. La couche de silicium amorphe 5a déposée sous la couche d'aluminium 4 se retrouve après recuit à l'extérieur de l'empilement sous forme d'une couche cristalline 5c. L'étape de gravure est inutile et la couche d'aluminium 4 persiste dans l'électrode finie sous la couche de silicium cristallin 5c.

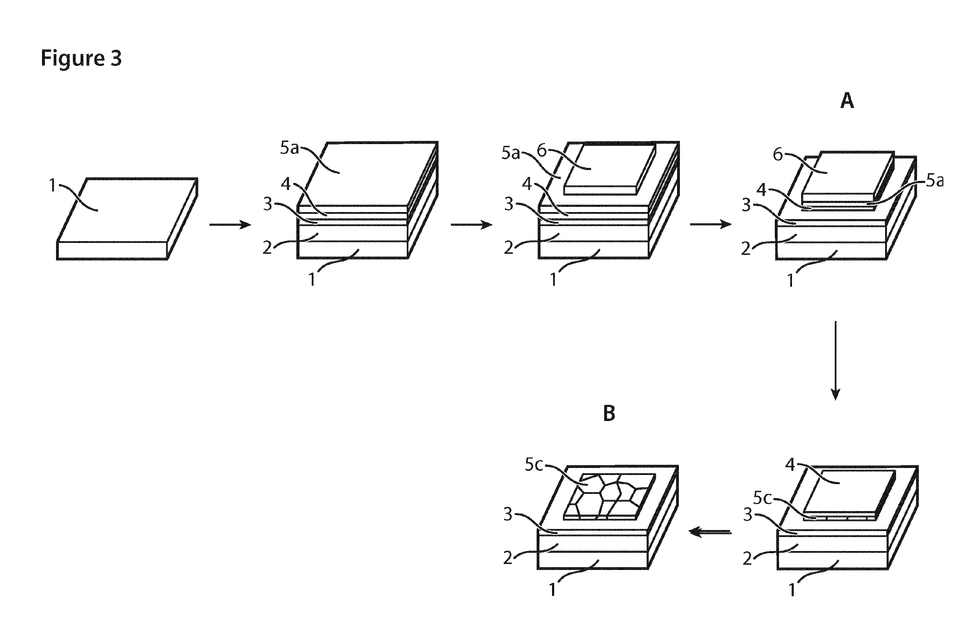

Enfin, le troisième mode de réalisation représenté à la figure 3 diffère de celui de la figure 1 par le fait qu'il comprend en outre le dépôt d'une résine photosensible 6 au-dessus de la couche de silicium amorphe 5a. Cette couche de résine photosensible 6 joue le rôle de masque dans une étape de structuration par gravure au cours de laquelle certaines zones des couches 4 et 5a sont éliminées. Après recuit et élimination de la couche de résine photosensible 6 et de la couche d'aluminium 4, on obtient une électrode où la couche de nucléation 5c est structurée, c'est-à-dire ne recouvre pas la totalité de la couche de barrière 3.

### Exemple

### (a) Dépôt de l'électrode

Sur un substrat formé par une plaquette de Si(001) couverte d'une couche de SiO₂ amorphe de rugosité Rq de 0,8 nm (mesurée par microscopie à force atomique (AFM) sur une surface de 1 µm²) on dépose par pulvérisation cathodique magnétron, en courant continu, une couche métallique de 50 nm d'épaisseur, dans les conditions de dépôt suivantes :

| **Métal** | **Pression d'Ar** | **Puissance** | **Potentiel** | **Température** | **Épaisseur** | **Vitesse** | **Durée** |
|---|---|---|---|---|---|---|---|
| | 10⁻⁶ bar | W | V | °C | nm | nm s⁻¹ | s |
| Ti | 3,5 | 100 | -22 | 20 | 2 | 0,13 | 15 |
| Ag | 3,5 | 100 | -22 | 20 | 50 | 1,46 | 34 |
| Mo | 3,5 | 200 | -75 | 20 | 50 | 0,54 | 93 |
| W | 3,5 | 200 | -75 | 20 | 50 | 0,53 | 94 |

| | | | | | | | |
|---|---|---|---|---|---|---|---|
| Note : la couche de 2 nm de Ti sert de couche d'accroche à la couche d'Ag). | | | | | | | |

Sur les électrodes métalliques ainsi obtenues, on détermine la rugosité par AFM. Le tableau suivant résume les résultats obtenus :

| **Métal** | **Rugosité *R*_{q}** |
|---|---|
| | nm |
| Ag | 1,0 |
| Mo | 5,8×10⁻¹ |
| W | 6,9×10⁻¹ |

### (b) Dépôt de la couche barrière

Une couche de 20 nm de nitrure de titane (TiN) (couche barrière) est ensuite déposée sur les couches métalliques de 50 nm d'épaisseur. Cette couche TiN est déposée par pulvérisation cathodique magnétron en courant continu, à partir d'une cible de titane (Ti), pulvérisée à l'aide d'un mélange gazeux argon (flux de 30 sccm) et azote (22 sccm), selon les conditions suivantes :

| **Matériau** | **Pression tot.** | **Flux Ar** | **Flux N₂** | **Puiss.** | **Pot.** | **Temp.** | **Ép.** | **Vitesse** | **Durée** |
|---|---|---|---|---|---|---|---|---|---|
| | 10⁻⁶ bar | sccm | sccm | W | V | °C | nm | nm s⁻¹ | s |
| TiN | 4,2 | 30 | 22 | 100 | -22 | 20 | 20,0 | 4,13×10⁻² | 484 |

### (c) Dépôt de la bicouche Al/a-Si

Une couche de 10 nm d'aluminium (Al) est ensuite déposée sur les échantillons précédents. Cette couche est déposée par pulvérisation cathodique magnétron en courant continu, selon les conditions suivantes :

| **Matériau** | **Pression tot.** | **Flux Ar** | **Puiss.** | **Pot.** | **Temp.** | **Ép.** | **Vitesse** | **Durée** |
|---|---|---|---|---|---|---|---|---|
| | 10⁻⁶ bar | sccm | W | V | °C | nm | nm s⁻¹ | s |
| Al | 3,8 | 30 | 100 | -22 | 20 | 10,0 | 4,16×10⁻¹ | 24 |

L'échantillon est exposé à l'air pendant 48 h pour laisser la couche d'aluminium s'oxyder, avant de recevoir le dépôt d'une couche de silicium amorphe de 15 nm d'épaisseur, réalisé également par pulvérisation cathodique magnétron en courant continu, selon les conditions suivantes :

| **Matériau** | **Pression tot.** | **Flux Ar** | **Puiss.** | **Pot.** | **Temp.** | **Ép.** | **Vitesse** | **Durée** |
|---|---|---|---|---|---|---|---|---|
| | 10⁻⁶ bar | sccm | W | V | °C | nm | nm s⁻¹ | s |
| Si | 3,8 | 30 | 100 | -22 | 20 | 15,0 | 2,08×10⁻¹ | 72 |

### (d) Recuit et gravure

Les empilements silice-métal/TiN/Al/a-Si sont recuits sous atmosphère inerte (azote) pendant 10 h à une température de 500 °C. Durant cette étape, la couche de silicium amorphe cristallise et rejette la couche d'aluminium à la surface.

Une gravure de 15 s dans une solution de HF diluée à 5% permet de retirer la couche d'aluminium.

### (e) Caractérisation

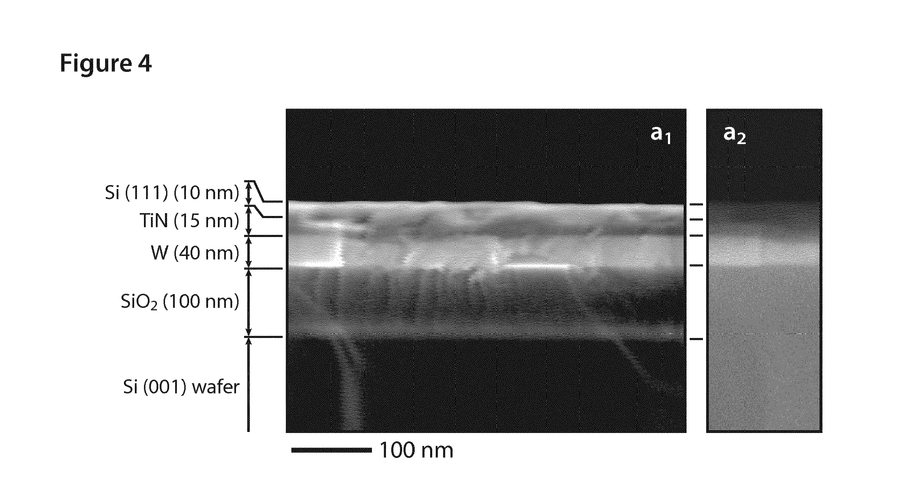

La figure 4 comprend deux clichés de microscopie électronique à balayage :
(a1): observation en mode « électrons secondaires » donnant principalement un contraste topologique ;
(a2) : observation en mode « électrons rétrodiffusés » donnant principalement un contraste chimique.

Cette figure permet de vérifier l'empilement des couches à la fin du procédé de fabrication de l'électrode pour l'épitaxie.

L'empilement présenté comporte successivement :
- une couche de silice amorphe (SiO₂) de 100 nm d'épaisseur, sur une plaquette de Si(100) ;
- une couche électrode de tungstène (W) de 40 nm d'épaisseur environ ;
- une couche barrière de diffusion en nitrure de titane (TiN) de 15 nm d'épaisseur ;
- une couche d'épitaxie de silicium cristallisé, d'orientation [111].

La figure (a2) permet de facilement détecter les frontières entre les couches, grâce au contraste de composition chimique.

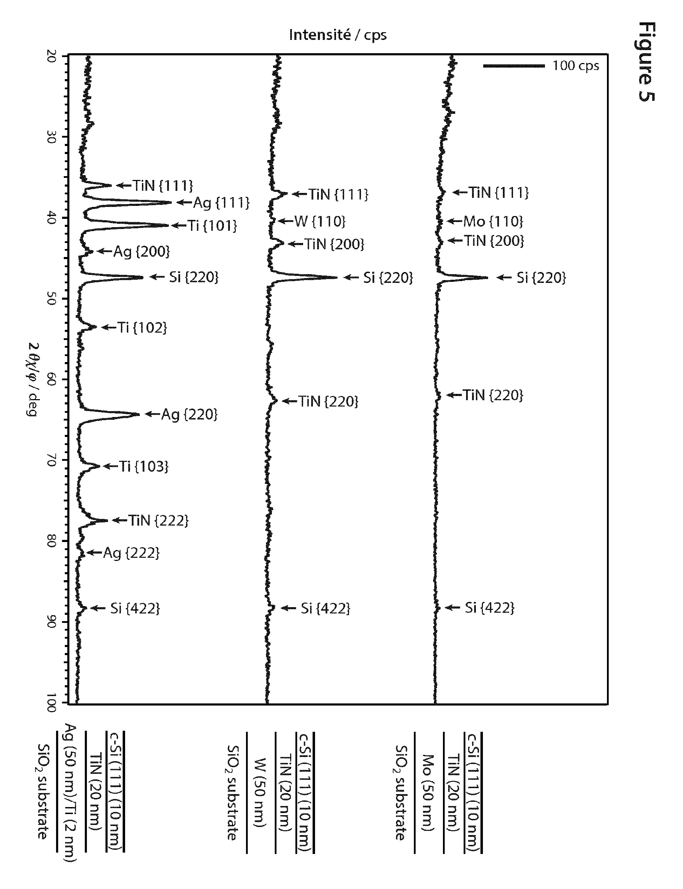

Les trois empilements dont la fabrication a été précédemment décrite ont été étudiés par diffraction des rayons X en incidence rasante (0,3°). Les spectres de diffraction sont présentés à la Figure 5.

### Empilement SiO₂-Mo/TiN/c-Si :

Pics TiN {111} et {220} mettant en évidence une cristallisation de la couche barrière de TiN, *a priori* sans orientation prédominante.

Pics Mo {110} : le molybdène étant la couche la plus enterrée, son signal de diffraction en incidence rasante est faible.

Les pics Si {220} et {422}, avec absence des autres pics du Si, démontrent l'orientation prédominante [111].

### Empilement SiO₂-W/TiN/c-Si :

Pics TiN {111} et {220} mettant en évidence une cristallisation de la couche barrière de TiN, *a priori* sans orientation prédominante.

Pic W {110} : le tungstène étant la couche la plus enterrée, son signal de diffraction en incidence rasante est faible.

Les pics Si {220} et {422}, avec absence des autres pics du Si, démontrent également l'orientation prédominante [111].

### Empilement SiO₂-Ti/Ag/TiN/c-Si :

Pics TiN {111} et {222} mettant en évidence une cristallisation de la couche barrière de TiN, a priori sans orientation prédominante.

Pics Ag {111}, {200}, et {222} des grains d'argent.

Pics Ti {101}, {102} et {103} sont relatifs aux grains de Ti ayant servi de couche d'accroche pour le dépôt de la couche d'argent.

Les pics Si {220} et {422}, avec absence des autres pics du Si, démontrent encore une fois l'orientation prédominante [111].

La résistance par carré des trois électrodes obtenues, portant chacune une couche de nucléation Si(111), a été mesurée par la méthode des quatre pointes. Les résultats sont rassemblés dans le tableau suivant :

| **Empilement** | ***R*□** |
|---|---|
| | **Ω/**□ |
| Ti/Ag/TiN/c-Si | 0,37 (±0,02) |
| Mo/TiN/c-Si | 0,19 (±0,01) |
| W/TiN/c-Si | 1, 20 (±0,1) |

Cet exemple montre qu'il a été possible de fabriquer des électrodes à base de Ag, Mo ou W, comportant à leur surface une très fine couche de silicium cristallin ayant une orientation prédominante [111].

## Revendications

1. Electrode comportant une couche de nucléation pour la croissance épitaxiale, comportant successivement
(a) une couche électro-conductrice (2) présentant une rugosité de surface telle que le Rq (norme ISO 4287) est inférieur à 20 nm, de préférence inférieur à 10 nm, en particulier inférieur à 5 nm, ladite couche électro-conductrice étant de préférence supportée par un substrat (1),
(b) une couche barrière (3) d'un nitrure métallique électro-conducteur choisi parmi les nitrures de titane (TiN), de bore (BN), de tantale (TaN), d'aluminium (AIN), de tungstène (W₂N), de molybdène (Mo₂N), de niobium (NbN) et de chrome (CrN), présentant une épaisseur comprise entre 2 nm et 100 nm, de préférence entre 5 et 50 nm et en particulier entre 8 et 20 nm, et
(d) une couche de silicium et/ou de germanium cristallin (5c) constituée d'un ou plusieurs monocristaux, jointifs ou non, tous orientés de sorte que leur plan cristallin (111) soit sensiblement parallèle à la surface de la couche barrière (3) et présentant une épaisseur inférieure à 100 nm, de préférence comprise entre 10 et 80 nm, en particulier entre 15 et 50 nm.

2. Electrode selon la revendication 1, **caractérisée par le fait qu'**elle comporte en outre entre la couche barrière (3) et la couche de silicium et/ou de germanium cristallin (5c),
(c) une couche d'un métal choisi parmi Al, Ag, Au, de préférence une couche de Al, ayant de préférence une épaisseur comprise entre 70 % et 100 % de l'épaisseur de la couche (5c).

3. Electrode selon l'une quelconque des revendications précédentes, **caractérisée par le fait que** la couche de silicium et/ou de germanium cristallin (5c) est constituée d'une pluralité de domaines non jointifs, chacun des domaines pouvant être constitué d'un monocristal unique ou de plusieurs monocristaux jointifs.

4. Précurseur de l'électrode selon l'une des revendications précédentes, comportant successivement
(a) une couche électro-conductrice (2) présentant une rugosité de surface telle que le Rq (norme ISO 4287) est inférieur à 20 nm, de préférence inférieur à 10 nm, en particulier inférieur à 5 nm, ladite couche électro-conductrice étant de préférence supportée par un substrat (1),
(b) une couche barrière (3) d'un nitrure métallique électro-conducteur choisi parmi les nitrures de titane (TiN), de bore (BN), de tantale (TaN), d'aluminium (AIN), de tungstène (W₂N), de molybdène (Mo₂N), de niobium (NbN) et de chrome (CrN), présentant une épaisseur comprise entre 2 nm et 100 nm, de préférence entre 5 et 50 nm et en particulier entre 8 et 20 nm,
(c) une couche (4) d'un métal choisi parmi Al, Ag et Au, de préférence Al, et
(d) une couche de silicium et/ou germanium amorphe (5a), présentant une épaisseur inférieure à 100 nm, de préférence comprise entre 10 et 80 nm, en particulier entre 15 et 50 nm, directement en contact avec la couche (4),
l'ordre des couches (4) et (5a) pouvant être inversé de manière à ce que la couche de silicium et/ou germanium amorphe (5a) se trouve sous la couche d'Al, Ag ou Au (4).

5. Précurseur d'électrode selon la revendication 4, **caractérisé par le fait que** la couche (4) a une épaisseur comprise entre 70 % et 100 % de la couche de silicium et/ou germanium amorphe (5a).

6. Précurseur d'électrode selon l'une quelconque des revendications 4 et 5, **caractérisée par le fait que** la couche de silicium et/ou germanium amorphe (5a) est constituée d'une multitude de domaines non jointifs.

7. Précurseur d'électrode selon l'une quelconque des revendications 4 à 6, **caractérisée par le fait que** la couche électro-conductrice est une couche métallique, de préférence une couche d'aluminium (Al), de molybdène (Mo), d'argent (Ag), de tungstène (W), d'or (Au), de cuivre (Cu), de titane (Ti), de chrome (Cr), de fer (Fe), de zinc (Zn), ou une couche d'un oxyde métallique conducteur choisi de préférence parmi les oxydes conducteurs transparents, en particulier parmi l'oxyde de zinc dopé à l'aluminium, au gallium et/ou à l'indium, l'oxyde d'étain dopé à l'indium (ITO), l'oxyde d'étain et de zinc (SnZnO) ou le dioxyde d'étain (SnO₂).

8. Procédé de fabrication d'une électrode comportant une couche de germes cristallins pour la croissance épitaxiale selon l'une quelconque des revendications 1 à 3, à partir d'un précurseur d'électrode tel que défini dans les revendications 4 à 6, ledit procédé comprenant le chauffage dudit précurseur d'électrode à une température et pendant une durée suffisantes pour effectuer la cristallisation de la couche de silicium et/ou germanium amorphe (5a) au contact de la couche métallique (4) et l'inversion des positions respectives des couches (4) et (5c) dans l'empilement de couches.

9. Procédé selon la revendication 8, **caractérisé par le fait que** la température de chauffage est comprise entre 250 °C et 550 °C, de préférence entre 300 °C et 500 °C, pour une durée de chauffage comprise entre 0,5 minute et 1 heure, de préférence entre 1 minute et 30 minutes.

10. Procédé selon la revendication 8 ou 9, **caractérisé par le fait qu'**il comprend en outre, après l'étape de cristallisation, une étape d'élimination de la couche métallique superficielle par gravure chimique.

11. Procédé de fabrication d'un précurseur d'électrode selon l'une quelconque des revendications 4 à 6, comprenant les étapes successives suivantes :
(i) dépôt d'une couche barrière (3) d'un nitrure métallique électro-conducteur choisi parmi les nitrures de titane (TiN), de bore (BN), de tantale (TaN), d'aluminium (AIN), de tungstène (W₂N), de molybdène (Mo₂N), de niobium (NbN) et de chrome (CrN), présentant une épaisseur comprise entre 2 nm et 100 nm, de préférence entre 5 et 50 nm et en particulier entre 8 et 20 nm, sur une couche électro-conductrice (2) présentant une rugosité de surface telle que le Rq (norme ISO 4287) est inférieur à 20 nm, de préférence inférieur à 10 nm, en particulier inférieur à 5 nm, éventuellement supportée par un substrat solide (1),
(ii) dépôt, sur la couche barrière (3) déposée à l'étape (i), d'une bi-couche formée d'une couche de silicium et/ou de germanium amorphe (5a) et d'une couche d'aluminium (4), les deux couches présentant chacune une épaisseur inférieure à 100 nm, de préférence comprise entre 10 et 80 nm, en particulier entre 15 et 50 nm, et pouvant être déposées dans n'importe quel ordre.

12. Procédé selon la revendication 11, **caractérisé par le fait que** chacune des étapes (i) et (ii) se fait indépendamment par dépôt chimique en phase vapeur (CVD), avec ou sans plasma, en particulier par dépôt de couche atomique (ALD), par dépôt physique en phase vapeur (PVD), en particulier par évaporation sous vide, par pulvérisation cathodique magnétron, par pulvérisation par faisceau d'ions ou par ablation par laser pulsé.
